# EUROPEAN PATENT APPLICATION

(11) **EP 4 601 432 A1**
(43) Date of publication of application: **13.08.2025**
(21) Application number: 24206675.1
(22) Date of filing: 15.10.2024
(51) Int. Cl.: H10D 1/68, H10B 12/00

(54) **CAPACITOR AND ELECTRONIC DEVICE INCLUDING THE SAME**

(30) Priority: 06.02.2024 KR 20240018420
(71) Applicant: Samsung Electronics Co., Ltd, Suwon-si, Gyeonggi-do 16677 (KR)
(72) Inventor: KIM, Haeryong, 16678 Suwon-si (KR); CHO, Eunae, 16678 Suwon-si (KR); WON, Jungyun, 16678 Suwon-si (KR); LEE, Jooho, 16678 Suwon-si (KR); HAN, Narae, 16678 Suwon-si (KR)
(74) Representative: Elkington and Fife LLP

(57) **Abstract**

Provided are a capacitor and an electronic device including the same. The capacitor (100) includes a first electrode (110), a second electrode (120) facing the first electrode, and a dielectric layer (130) between the first electrode and the second electrode. The dielectric layer includes an intervening layer (132) in the dielectric layer, and the intervening layer includes aluminum oxide and gallium oxide.

## Description

### FIELD OF THE INVENTION

The disclosure relates to a capacitor and an electronic device including the same.

### BACKGROUND OF THE INVENTION

As the degree of integration of electronic devices, such as memories, increases, the demand for electronic elements in the electronic devices becoming more miniaturized is also increasing. However, because the capacitance of a capacitor is proportional to the area of the capacitor, the capacitance may decrease as the capacitor is miniaturized. Therefore, in order to compensate for the decrease in size of a capacitor and secure a desired capacitance, studies have been conducted into a method of further increasing a dielectric constant of a dielectric layer. In addition, studies have been conducted on a method of suppressing an increase in leakage current due to miniaturization of capacitors.

### SUMMARY OF THE INVENTION

Provided are a capacitor with improved leakage current characteristics and an electronic device including the capacitor.

Provided are a capacitor with a dielectric layer having a relatively high dielectric constant and an electronic device including the capacitor.

Additional aspects will be set forth in part in the description which follows and, in part, will be apparent from the description, or may be learned by practice of the presented embodiments of the disclosure.

According to an aspect of the disclosure, a capacitor includes a first electrode, a second electrode facing the first electrode, and a dielectric layer between the first electrode and the second electrode, the dielectric layer including an intervening layer in the dielectric layer, and the intervening layer including aluminum oxide and gallium oxide.

The intervening layer may include AlₐGa_{b}O₃, wherein 0<a<2 and 0<b<2.

A ratio of aluminum to gallium in the intervening layer may satisfy 0.1≤b/a≤1.

Alternatively, a ratio of aluminum to gallium in the intervening layer may satisfy 0.33≤b/a≤1.

The dielectric layer may further include a first dielectric material layer adjacent to the first electrode and a second dielectric material layer adjacent to the second electrode, and wherein the intervening layer may be between the first dielectric material layer and the second dielectric material layer.

The first dielectric material layer and the second dielectric material layer may include a same dielectric material.

Each of the first dielectric material layer and the second dielectric material layer may include a dielectric material is different from a dielectric material of the intervening layer.

For example, each of the first dielectric material layer and the second dielectric material layer may include at least one dielectric material selected from zirconium oxide, hafnium oxide, hafnium zirconium oxide, a perovskite, or a mixture thereof.

A composition ratio of the aluminum oxide and a composition ratio of the gallium oxide may continuously change along the first dielectric material layer, the intervening layer, and the second dielectric material layer.

A peak of the composition ratio of the aluminum oxide and a peak of the composition ratio of the gallium oxide may be inside the intervening layer.

The peak of the composition ratio of the aluminum oxide and the peak of the composition ratio of the gallium oxide may be at a same position inside the intervening layer.

The composition ratio of the aluminum oxide and the gallium oxide may continuously increase toward the intervening layer at an interface between the first dielectric material layer and the intervening layer and may continuously decrease from the intervening layer toward the second dielectric material layer.

Materials of the first dielectric material layer and the second dielectric material layer may be distributed in the intervening layer.

At a center of the intervening layer, a composition ratio of the materials of the first dielectric material layer and the second dielectric material layer may be less than a sum of composition ratios of the aluminum oxide and the gallium oxide.

At a center of the intervening layer, a composition ratio of the materials of the first dielectric material layer and the second dielectric material layer may be less than a composition ratio of the aluminum oxide.

At a center of the intervening layer, a composition ratio of the materials of the first dielectric material layer and the second dielectric material layer may be greater than a composition ratio of the gallium oxide.

For example, the dielectric layer may have a thickness of about 3 nm to about 10 nm.

For example, the intervening layer may have a thickness of 1 nm or less.

Each of the first electrode and the second electrode may include at least one conductive metal selected from titanium (Ti), nickel (Ni), aluminum (Al), tantalum (Ta), tungsten (W), platinum (Pt), lead (Pd), gold (Au), iridium (Ir), rhodium (Rh), molybdenum (Mo), vanadium (V), niobium (Nb), ruthenium (Ru), and cobalt (Co), a conductive metal oxide of the at least one conductive metal, a conductive metal nitride of the at least one conductive metal, or a combination thereof.

According to another aspect of the disclosure, an electronic device includes a transistor, and a capacitor electrically connected to the transistor, wherein the capacitor includes a first electrode, a second electrode facing the first electrode, and a dielectric layer between the first electrode and the second electrode, the dielectric layer includes an intervening layer in the dielectric layer, and the intervening layer includes aluminum oxide and gallium oxide.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view illustrating a schematic structure of a capacitor according to at least one embodiment;
FIG. 2 is a graph showing a radial distribution function (RDF) of a dielectric layer according to materials included in an intervening layer;
FIG. 3 is a graph showing tetragonality of various materials;
FIG. 4A is a graph showing X-ray diffraction (XRD) patterns for an intervening layer including only aluminum (Al) and FIG. 4B and FIG. 4C are graphs showing X-ray diffraction (XRD) patterns for an intervening layer including both aluminum (Al) and gallium (Ga);
FIG. 5 is a graph showing an example of capacitance of a capacitor for various materials of an intervening layer;
FIG. 6 is a graph showing an example of an oxygen composition distribution in a capacitor for various materials of an intervening layer;
FIG. 7 is a graph showing an example of leakage current characteristics of a capacitor for various materials of an intervening layer;
FIG. 8 is a cross-sectional view illustrating a schematic structure of a capacitor according to another embodiment;
FIGS. 9 and 10 are graphs showing an example of a change in composition of materials in a capacitor according to at least one embodiment;
FIG. 11 is a circuit diagram for describing a schematic circuit configuration and operation of an electronic device employing a capacitor, according to embodiments;
FIG. 12 is a schematic diagram illustrating an electronic device according to at least one embodiment;
FIG. 13 is a schematic diagram illustrating an electronic device according to another at least one embodiment;
FIG. 14 is a plan view illustrating an electronic device according to another at least one embodiment;
FIG. 15 is a cross-sectional view of the electronic device taken along line A-A' of FIG. 14;
FIG. 16 is a cross-sectional view illustrating an electronic device according to another at least one embodiment; and
FIGS. 17 and 18 are conceptual diagrams schematically illustrating a device architecture applicable to a device according to at least one embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a capacitor and an electronic device including the same will be described in detail with reference to the accompanying drawings. In the following drawings, the same reference numerals denote the same elements, and the size of each element in the drawings may be exaggerated for clarity and convenience of explanation. In addition, embodiments described herein are merely examples, and various modifications may be made thereto from these embodiments.

Hereinafter, the terms "above" or "on" may include not only those that are directly on in a contact manner, but also those that are above in a non-contact manner. Additionally, it will be understood that such spatially relative terms, such as "above," "top," etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The singular forms as used herein are intended to include the plural forms as well unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order. Additionally, whenever a range of values is enumerated, the range includes all values within the range as if recorded explicitly clearly, and may further include the boundaries of the range. Accordingly, the range of "X" to "Y" includes all values between X and Y, including X and Y. Further, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

Also, the terms such as "unit" and "module" described in the specification mean units that process at least one function or operation, and may be implemented as processing circuitry such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may also include electrical components such as at least one of transistors, resistors, capacitors, etc., and/or electronic circuits including said components.

Connecting lines or connecting members illustrated in the drawings are intended to represent exemplary functional relationships and/or physical or logical connections between the various elements. It should be noted that many alternative or additional functional relationships, physical connections or logical connections may be present in a practical device.

The use of all illustrations or illustrative terms in the embodiments is simply to describe the technical ideas in detail, and the scope of the inventive concept is not limited by the illustrations or illustrative terms unless they are limited by claims.

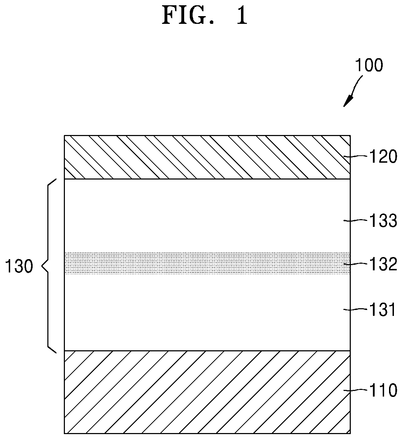

FIG. 1 is a cross-sectional view illustrating a schematic structure of a capacitor 100 according to at least one embodiment. Referring to FIG. 1, the capacitor 100 may include a first electrode 110, a second electrode 120 facing the first electrode 110, and a dielectric layer 130 disposed between the first electrode 110 and the second electrode 120. In addition, the dielectric layer 130 may include an intervening layer 132 provided within the dielectric layer 130.

In at least some embodiments, the first electrode 110 may be disposed on a substrate (not shown). The substrate may be a portion of a structure that supports the capacitor 100 and/or may be a portion of an element connected to the capacitor 100. The substrate may include a semiconductor material pattern, an insulating material pattern, and/or a conductive material pattern. The substrate may include, for example, a semiconductor material, such as silicon (Si), germanium (Ge), silicon germanium (SiGe), silicon carbide (SiC), gallium arsenide (GaAs), indium arsenide (InAs), or indium phosphide (InP), and/or an insulating material, such as silicon oxide, silicon nitride, or silicon oxynitride.

The second electrode 120 may be spaced apart from the first electrode 110 and disposed to face the first electrode 110. Each of the first electrode 110 and the second electrode 120 may include a conductive material, such as metal, metal nitride, metal oxide, and/or a combination thereof. For example, each of the first electrode 110 and the second electrode 120 may include at least one conductive metal selected from titanium (Ti), nickel (Ni), aluminum (Al), tantalum (Ta), tungsten (W), platinum (Pt), lead (Pd), gold (Au), iridium (Ir), rhodium (Rh), molybdenum (Mo), vanadium (V), niobium (Nb), ruthenium (Ru), and cobalt (Co), and/or may include a conductive metal oxide of the at least one conductive metal and/or a conductive metal nitride of the at least one conductive metal. The conductive metal oxide may include, for example, platinum oxide (PtO), iridium oxide (IrO₂), ruthenium oxide (RuO₂), strontium ruthenium oxide (SrRuO₃), barium strontium ruthenium oxide ((Ba,Sr)RuO₃), calcium ruthenium oxide (CaRuO₃), lanthanum strontium cobalt oxide ((La,Sr)CoO₃), and/or the like. The conductive metal nitride may include, for example, titanium nitride (TiN), tantalum nitride (TaN), niobium nitride (NbN), molybdenum nitride (MoN), cobalt nitride (CoN), tungsten nitride (WN), and/or the like.

Each of the first electrode 110 and the second electrode 120 may have a single-layer structure or a stacked structure of a plurality of material layers. For example, each of the first electrode 110 and the second electrode 120 may include a single layer of titanium nitride (TiN) or a single layer of niobium nitride (NbN). Alternatively, each of the first electrode 110 and the second electrode 120 may have a stacked structure in which titanium nitride (TiN) and niobium nitride (NbN) are repeatedly stacked at least once.

In another example, each of the first electrode 110 and the second electrode 120 may include metal nitride represented by MM'N. M is a metal element, M' is an element that is different from M, and N is nitrogen. For the example, the MM'N metal nitride may include MN metal nitride doped with the element M'. M may be at least one element selected from Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl, Pb, Bi, Po, Fr, Ra, Ac, Th, Pa, and U. M' may be at least one element selected from H, Li, As, Se, N, O, P, S, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Mo, Tc, Ru, Rh, Pd, Ag, Cd, In, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Tl, Pb, Bi, Po, Fr, Ra, Ac, Th, Pa, and U. In at least some embodiments, the composition ratio of M, M', and N in the metal nitride MM'N is x:y:z, wherein 0≤x≤2, 0≤y≤2, and 0<z≤4, and wherein at least one of x or y may not be 0.

The dielectric layer 130 may include a first dielectric material layer 131, the intervening layer 132, and a second dielectric material layer 133. The first dielectric material layer 131 may be disposed adjacent to the first electrode 110, and the second dielectric material layer 133 may be apart from the first dielectric material layer 131 and disposed adjacent to the second electrode 120. The intervening layer 132 may be provided between the first dielectric material layer 131 and the second dielectric material layer 133. In other words, the first dielectric material layer 131, the intervening layer 132, and the second dielectric material layer 133 may be sequentially disposed in this stated order in the thickness direction of the dielectric layer 130.

The first dielectric material layer 131 and the second dielectric material layer 133 may include the same dielectric material. In this respect, it may be stated that the intervening layer 132 is further disposed within one dielectric material of the dielectric layer 130. Each of the first dielectric material layer 131 and the second dielectric material layer 133 may include a metal oxide material having a tetragonal crystal structure and/or a crystal structure similar thereto and a dielectric constant of about 20 to about 70. For example, each of the first dielectric material layer 131 and the second dielectric material layer 133 may include at least one dielectric material selected from zirconium oxide (ZrO₂), hafnium oxide (HfO₂), hafnium zirconium oxide (HfZrO₂), a perovskite, and/or a mixture thereof. For example, the perovskite may include SrTiO₃, CaTiO₃, BaTiO₃, Pb(Zr, Ti)O₃, PbZnNbO₃, etc.

The intervening layer 132 may include a dielectric material that is different from that of each of the first dielectric material layer 131 and the second dielectric material layer 133. In particular, the intervening layer 132 may include a metal oxide material that may suppress or reduce the formation of oxygen vacancies in the dielectric layer 130 without deteriorating the overall crystal characteristics of the dielectric layer 130 including the first dielectric material layer 131 and the second dielectric material layer 133. According to at least one embodiment, the intervening layer 132 may include aluminum oxide (AlO) and gallium oxide (GaO). For example, the intervening layer 132 may include AlₐGa_{b}O₃, wherein 0<a<2 and 0<b<2.

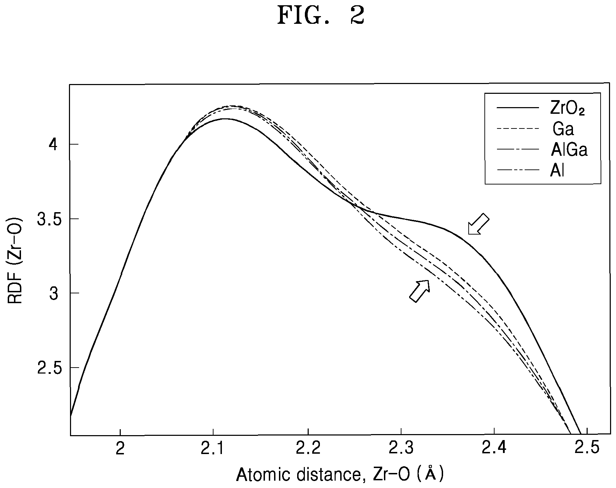

FIG. 2 is a graph showing a radial distribution function (RDF) of the dielectric layer 130 according to materials included in the intervening layer 132. For example, when each of the first dielectric material layer 131 and the second dielectric material layer 133 of the dielectric layer 130 includes zirconium oxide (ZrO₂), the horizontal axis in FIG. 2 may represent the atomic distance between a zirconium atom and an oxygen atom, and the vertical axis in FIG. 2 may represent the ratio of the entire atoms to the zirconium atom. Referring to FIG. 2, when the dielectric layer 130 includes only zirconium oxide (ZrO₂) (e.g., without the intervening layer 132), a first greatest peak appears between about 2.1 Å and about 2.2 Å, and a second peak appears between about 2.3 Å and about 2.4 Å. The second peak is a unique characteristic of a tetragonal phase crystal.

On the other hand, when the intervening layer 132 includes only aluminum (Al), the second peak hardly appears. Accordingly, when the intervening layer 132 includes only aluminum (Al), the crystallinity of the dielectric layer 130 deteriorates, and thus, the dielectric constant of the dielectric layer 130 decreases. As a result, the capacitance of the capacitor 100 may be reduced. In addition, when the intervening layer 132 includes only gallium (Ga), the second peak may appear. Even when the intervening layer 132 includes both aluminum (Al) and gallium (Ga), the second peak that is less than when the intervening layer 132 includes only gallium (Ga) and greater than when the intervening layer 132 includes only aluminum (Al) may appear.

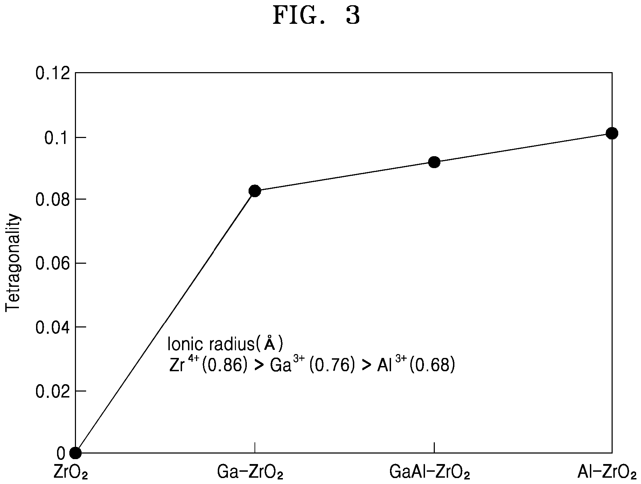

FIG. 3 is a graph showing tetragonality of various materials. In FIG. 3, tetragonality is an indicator representing the degree to which the crystals of materials deviate from the tetragonal phase. As the indicator is closer to 0, the tetragonal phase becomes more ideal. Referring to FIG. 3, the tetragonality of zirconium oxide (ZrO₂) is 0. Tetragonality decreases in the order of a material (Al-ZrO₂) further including only aluminum (Al) in zirconium oxide, a material (GaAl-ZrO₂) including aluminum (Al) and gallium (Ga) in zirconium oxide, and a material (Ga-ZrO₂) further including only gallium (Ga) in zirconium oxide. This is because the ionic radius of gallium ion (Ga³⁺) (about 0.76 Å) is greater than the ionic radius of aluminum ion (Al³⁺) (about 0.68 Å) and is closer to the ionic radius of zirconium ion (Zr⁴⁺) (about 0.86 Å).

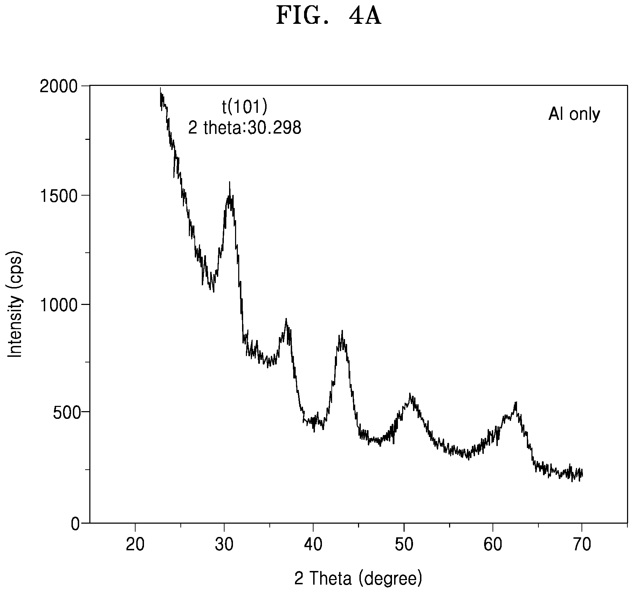

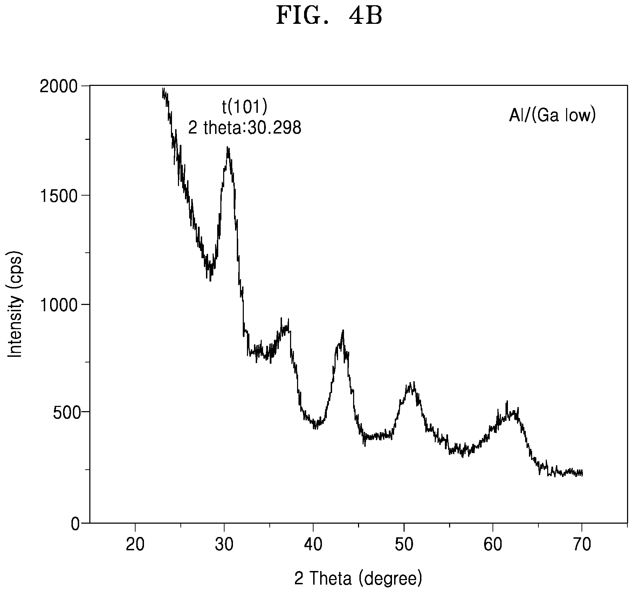

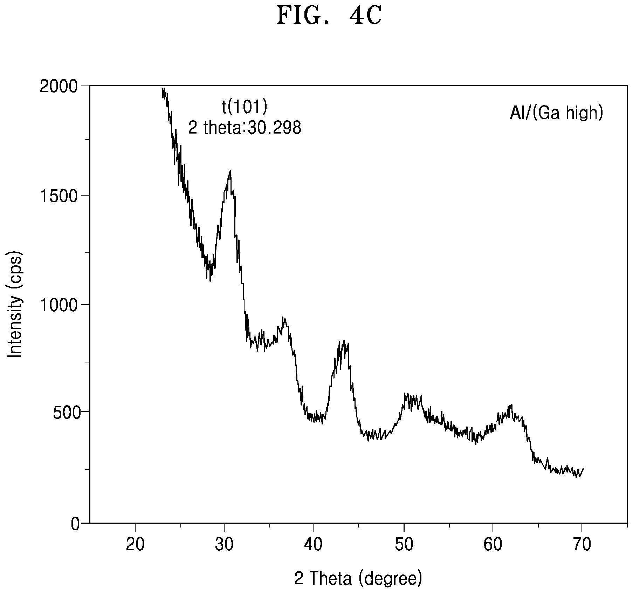

FIG. 4A is a graph showing X-ray diffraction (XRD) patterns for an intervening layer including only aluminum (Al) and FIG. 4B and FIG. 4C are graphs showing X-ray diffraction (XRD) patterns for an intervening layer including both aluminum (Al) and gallium (Ga). Referring to FIG. 4A, FIG. 4B and FIG. 4C, in a case were the intervening layer 132 includes both aluminum (Al) and gallium (Ga) ("Al/(Ga Low)" or "Al/(Ga High)"), a peak closer to 30.298 degrees occurs and an intensity of the peak is higher, compared to a case where the intervening layer 132 includes only aluminum (Al) ("Al only"). It may be seen through the peak of 30.298 degrees in the XRD pattern that in a case where the intervening layer 132 includes both aluminum (Al) and gallium (Ga), the crystallinity of the tetragonal phase is improved, compared to a case where the intervening layer 132 includes only aluminum (Al). In addition, in FIG. 4B and FIG. 4C, "Al/(Ga Low)" indicates a case where the ratio of gallium (Ga) to aluminum (Al) in the intervening layer 132 is 10 %, and "Al/(Ga High)" indicates a case where the ratio of gallium (Ga) to aluminum (Al) in the intervening layer 132 is 100 %. According to the graph in FIG. 4B and FIG. 4C, the crystallinity of the tetragonal phase may be more improved in "Al/(Ga High)" than in "Al/(Ga Low)."

As described above, because gallium (Ga), which has an ionic radius greater than that of aluminum ion while having a distribution structure similar to the distribution structure of the material of the first and second dielectric material layers 131 and 133 within the intervening layer 132, is used together as the oxide material of the intervening layer 132, a deterioration in crystallinity of the dielectric layer 130 due to the intervening layer 132 may be minimized. Accordingly, a reduction in capacitance of the capacitor 100 due to the intervening layer 132 may be minimized.

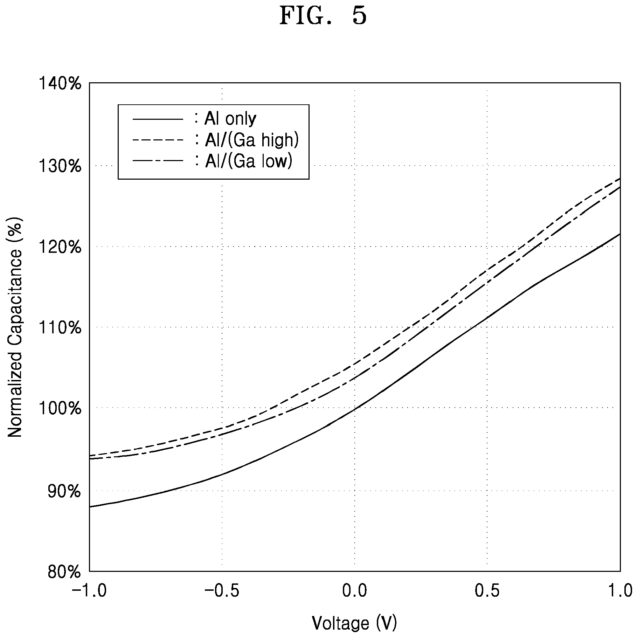

FIG. 5 is a graph showing an example of capacitance of the capacitor 100 for various materials of an intervening layer 132. Referring to FIG. 5, in a case were the intervening layer 132 includes both aluminum (Al) and gallium (Ga) ("Al/(Ga Low)" or "Al/(Ga High)"), the capacitance of the capacitor 100 is increased, compared to a case where the intervening layer 132 includes only aluminum (Al) ("Al only"). In addition, as the ratio of gallium (Ga) to aluminum (Al) in the intervening layer 132 increases, the capacitance of the capacitor 100 further increases.

On the other hand, the oxygen vacancy formation energy of aluminum (Al) in zirconium oxide (ZrO₂) is about -1.00 eV, the oxygen vacancy formation energy of gallium (Ga) is about - 0.89 eV, and the oxygen vacancy formation energy when both aluminum (Al) and gallium (Ga) are included is about -0.86 eV. Therefore, when the intervening layer 132 includes both aluminum oxide and gallium oxide, the oxygen vacancy formation energy may increase, and thus, the formation of oxygen vacancies in the dielectric layer 130 may be suppressed and the concentration of oxygen vacancies in the dielectric layer 130 may be reduced.

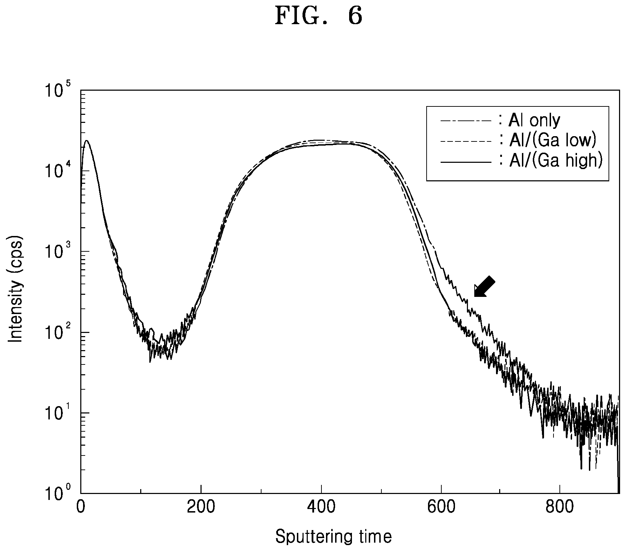

FIG. 6 is a graph showing an example of an oxygen composition distribution in the capacitor 100 for various materials of the intervening layer 132. The graph of FIG. 6 was obtained by measuring the oxygen distribution in the capacitor 100 by using secondary ion mass spectrometry (SIMS). Referring to FIG. 6, in a case where the intervening layer 132 includes only aluminum (Al), as indicated by an arrow, the amount of oxygen increases near the first electrode 110, compared to a case where the intervening layer 132 includes both aluminum (Al) and gallium (Ga) ("Al/(Ga Low)" or "Al/(Ga High)"). The increase in oxygen near the first electrode 110 may mean that oxygen in the dielectric layer 130 has diffused into the first electrode 110. The expression "the oxygen in the dielectric layer 130 has diffused into the first electrode 110" may imply that the oxygen in the dielectric layer 130 decreases accordingly, and thus the oxygen vacancies in the dielectric layer 130 increase. Further, since oxygen vacancies may suppress the dielectric constant of an oxide based dielectric, the increase in oxygen vacancies may reduce the capacitance of the capacitor 100. Therefore, the diffusion of the oxygen in the dielectric layer 130 into the first electrode 110 may be prevented and/or mitigated by the intervening layer 132 including both aluminum (Al) and gallium (Ga) ("Al/(Ga Low)" or "Al/(Ga High)") while maintaining the tetragonal phase.

Therefore, in a case where the intervening layer 132 includes both aluminum (Al) and gallium (Ga), the formation of oxygen vacancies in the dielectric layer 130 may be suppressed and the concentration of oxygen vacancies in the dielectric layer 130 may be reduced, compared with a case where the intervening layer 132 includes only aluminum (Al). Due to this, a leakage current due to the oxygen vacancies in the dielectric layer 130 may be reduced. In addition, when the intervening layer 132 includes both gallium (Ga) and aluminum (Al), leakage current characteristics may be further improved by reducing a valence band offset (VBO) at interfaces between the dielectric layer 130 and the first electrode 110 and between the dielectric layer 130 and the second electrode 120, compared to a case where the intervening layer 132 includes only aluminum (Al). For example, a VBO when the intervening layer 132 includes both gallium (Ga) and aluminum (Al) may be reduced by up to about 0.4 eV, compared to a case where the intervening layer 132 includes only aluminum (Al).

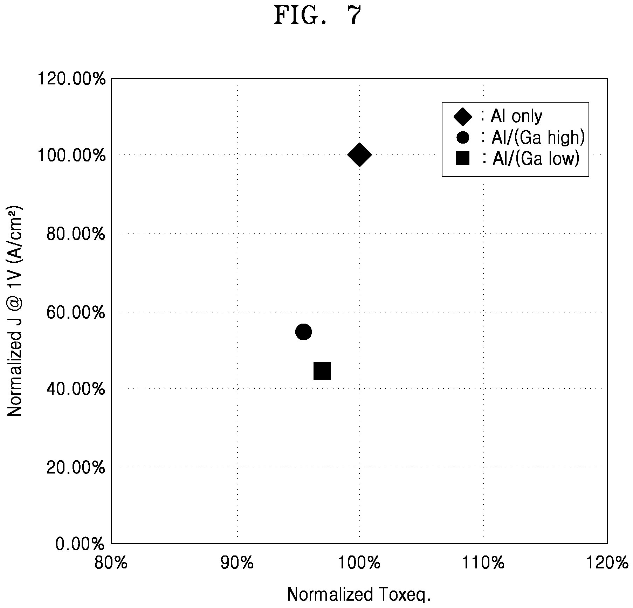

FIG. 7 is a graph showing an example of leakage current characteristics of the capacitor 100 for various materials of an intervening layer. Referring to FIG. 7, when the ratio of gallium (Ga) to aluminum (Al) in the intervening layer 132 is 100 % ("Al/(Ga High)"), an equivalent oxide thickness (Toxeq) is reduced by about 4.5 % and a leakage current is reduced by about 45.3 %, compared to a case where the intervening layer 132 includes only aluminum (Al). In addition, when the ratio of gallium (Ga) to aluminum (Al) in the intervening layer 132 is 10 % ("Al/(Ga Low)"), an equivalent oxide thickness (Toxeq) is reduced by about 2.9 % and a leakage current is reduced by about 55.6 %, compared to a case where the intervening layer 132 includes only aluminum (Al).

It may be seen from the graph of FIG. 7 that as the proportion of gallium (Ga) in the intervening layer 132 increases, the effect of reducing the equivalent oxide thickness (Toxeq) may increase, and as the proportion of gallium (Ga) in the intervening layer 132 decreases, the effect of reducing the leakage current may increase. Considering this, the ratio of gallium (Ga) to aluminum (Al) in the intervening layer 132 may be selected within an appropriate range. For example, the ratio of gallium (Ga) to aluminum (Al) in the intervening layer 132 may be selected within a range of about 10 % to about 100 %. Alternatively, the ratio of gallium (Ga) to aluminum (Al) in the intervening layer 132 may be selected within a range of about 25 % to about 100 %, a range of about 33 % to about 100 %, a range of about 25 % to about 80 %, or a range of about 33 % to about 80 %. In other words, when the intervening layer 132 includes AlₐGa_{b}O₃, a relationship of 0.1≤b/a≤1 may be satisfied. Alternatively, a relationships of 0.25≤b/a≤1, 0.33≤b/a≤1, 0.25≤b/a≤ 0.8, and/or 0.33≤b/a≤0.8 may be satisfied.

As described above, according to the disclosed embodiment, because the intervening layer 132 inserted into the dielectric layer 130 of the capacitor 100 has a tetragonality similar to that of the material of the dielectric layer 130, the crystallinity of the dielectric layer 130 may not deteriorate. In addition, the intervening layer 132 may suppress or reduce the formation of oxygen vacancies within the dielectric layer 130. Accordingly, the intervening layer 132 may reduce the leakage current while improving the capacitance of the capacitor 100. According to these embodiments, because the dielectric layer 130 has a high dielectric constant, the thickness of the dielectric layer 130 may be reduced and the capacitor 100 may be further miniaturized. For example, the dielectric layer 130 may have a thickness of about 3 nm to about 10 nm. In addition, the intervening layer 132 may have a thickness of about 0.1 nm to about 1 nm.

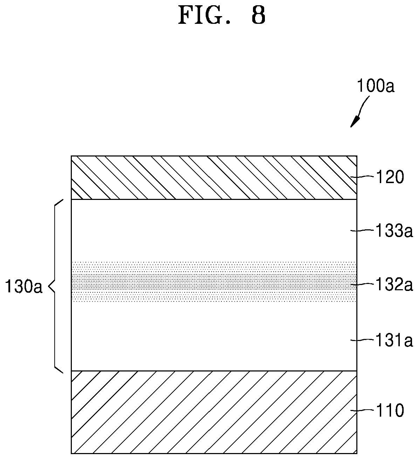

FIG. 8 is a cross-sectional view illustrating a schematic structure of a capacitor 100a according to another at least one embodiment. Referring to FIG. 8, a dielectric layer 130a of the capacitor 100a according to another at least one embodiment may include a first dielectric material layer 131a, an intervening layer 132a, and a second dielectric material layer 133a. Compared to the capacitor 100 illustrated in FIG. 1, a composition of materials may change continuously at a boundary between the first dielectric material layer 131a and the intervening layer 132a and a boundary between the second dielectric material layer 133a and the intervening layer 132a in the dielectric layer 130a of the capacitor 100a illustrated in FIG. 8. In other words, a composition ratio of aluminum (Al) and gallium (Ga) continuously change along the first dielectric material layer 131a, the intervening layer 132a, and the second dielectric material layer 133a, and peaks of the composition ratio of aluminum (Al) and the composition ratio of gallium (Ga) may be formed in the intervening layer 132a. In addition, the materials of the first and second dielectric material layers 131a and 133a may also be distributed inside the intervening layer 132a. As such, the interface between the intervening layer 132a and the first dielectric material layer 131a and/or the second dielectric material layer 133a may be described as being indistinct and the aluminum oxide and the gallium oxide may be referred to as gradually (or continuously) changing in the intervening layer 132a.

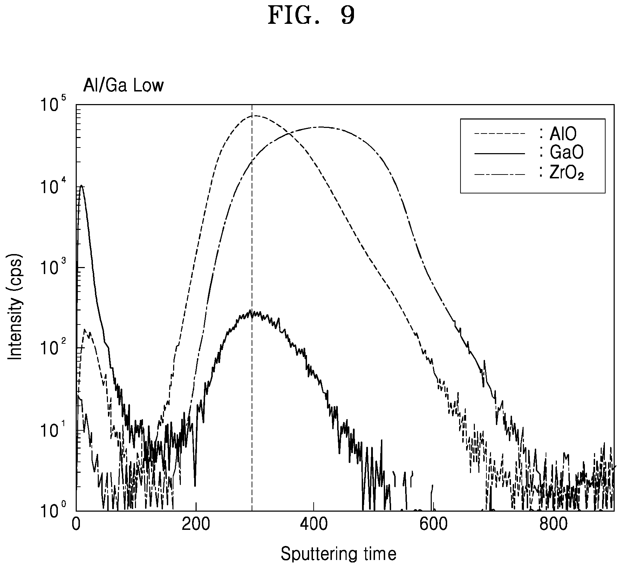

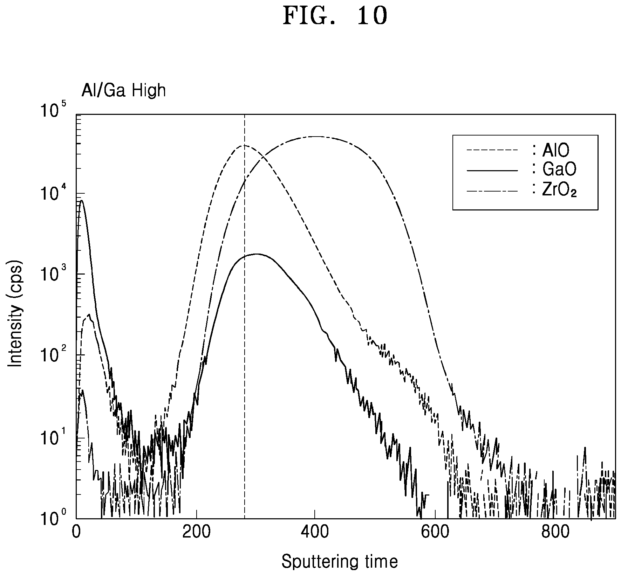

FIGS. 9 and 10 are graphs showing an example of a change in composition of materials around the intervening layer 132a of the capacitor 100a according to at least one embodiment. FIG. 9 and FIG. 10 differ only in the composition ratio of gallium (Ga) to aluminum (Al). The graphs of FIGS. 9 and 10 were obtained by measuring the distribution of aluminum (Al), gallium (Ga), and zirconium (Zr) in the intervening layer 132a of the capacitor 100a by using secondary-ion mass spectrometry (SIMS). Referring to FIGS. 9 and 10, aluminum oxide and gallium oxide begin to gradually increase from near a boundary between the first dielectric material layer 131a and the intervening layer 132a the intervening layer 132a and a peak of a composition ratio may be formed inside the intervening layer 132a. Then, aluminum oxide and gallium oxide may gradually decrease from the peak inside the intervening layer 132a towards the second dielectric material layer 133a. As illustrated in FIGS. 9 and 10, the peak of the composition ratio of aluminum oxide and the peak of the composition ratio of gallium oxide may be formed at the same position inside the intervening layer 132a. For example, the peak of the composition ratio of aluminum oxide and the peak of the composition ratio of gallium oxide may be formed at the center of the intervening layer 132a indicated by a dotted line. In addition, when the ratio of aluminum (Al) to gallium (Ga) is greater, aluminum (Al) may spread more widely than gallium (Ga), and thus, aluminum (Al) may be distributed in a wider range than gallium (Ga) within the dielectric layer 130.

In addition, the materials of the first and second dielectric material layers 131a and 133a may also be distributed in the intervening layer 132a. For example, zirconium oxide may be distributed in the first and second dielectric material layers 131a and 133a as well as the intervening layer 132a. The composition ratio of zirconium oxide may form a peak in the first dielectric material layer 131a or the second dielectric material layer 133a. The peak position of the composition ratio of zirconium oxide in the dielectric layer 130 may be different from the peak position of the composition ratio of aluminum oxide and the peak position of the composition ratio of gallium oxide. For example, the composition ratio of zirconium oxide may be less than the sum of the composition ratios of aluminum oxide and gallium oxide at the center of the intervening layer 132a indicated by a dotted line, at the peak position of the composition ratio of aluminum oxide, or at the peak position of the composition ratio of gallium oxide. For example, the composition ratio of zirconium oxide may be less than the composition ratio of aluminum oxide and greater than the composition ratio of gallium oxide at the center of the intervening layer 132a, at the peak position of the composition ratio of aluminum oxide, or at the peak position of the composition ratio of gallium oxide. The composition ratio of zirconium oxide in the first and second dielectric material layers 131a and 133a may be greater than the composition ratio of aluminum oxide and greater than the composition ratio of gallium oxide.

The capacitor may be employed in various electronic devices. For example, the capacitor may be used as a dynamic random access memory (DRAM) together with a transistor. In addition, the capacitor may be used for a portion of an electronic circuit constituting an electronic device together with other circuit elements.

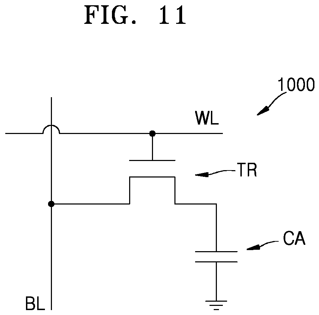

FIG. 11 is a circuit diagram for describing a schematic circuit configuration and operation of an electronic device 1000 employing a capacitor, according to embodiments.

The circuit diagram of the electronic device 1000 is for one cell of a DRAM, and the electronic device 1000 includes one transistor TR, one capacitor CA, a word line WL, and a bit line BL. The capacitor CA may be the capacitors 100 and/or 100a described with reference to FIGS. 1 to 10.

A method of writing data to the DRAM is as follows. After a gate voltage (high) for turning the transistor TR on ("ON" state) is applied to a gate electrode through the word line WL, VDD (hereinafter, a high voltage) or 0 (hereinafter, a low voltage), which is a data voltage value to be input, is applied to the bit line BL. When a high voltage is applied to the word line WL and the bit line BL, the capacitor CA is charged, that is, data "1" is written. When a high voltage is applied to the word line WL and a low voltage is applied to the bit line BL, the capacitor CA is discharged, that is, data "0" is written.

Upon reading data, a high voltage is applied to the word line WL to turn on the transistor TR of the DRAM, and a voltage of VDD/2 is applied to the bit line BL. When the data of the DRAM is "1," that is, when the voltage of the capacitor CA is VDD, charges stored in the capacitor CA slowly move to the bit line BL and the voltage of the bit line BL becomes slightly higher than VDD/2. In contrast, when the data of the capacitor CA is "0," charges of the bit line BL move to the capacitor CA and the voltage of the bit line BL becomes slightly lower than VDD/2. A sense amplifier may sense and amplify the potential difference of the bit line BL and determine whether the data is "0" or "1."

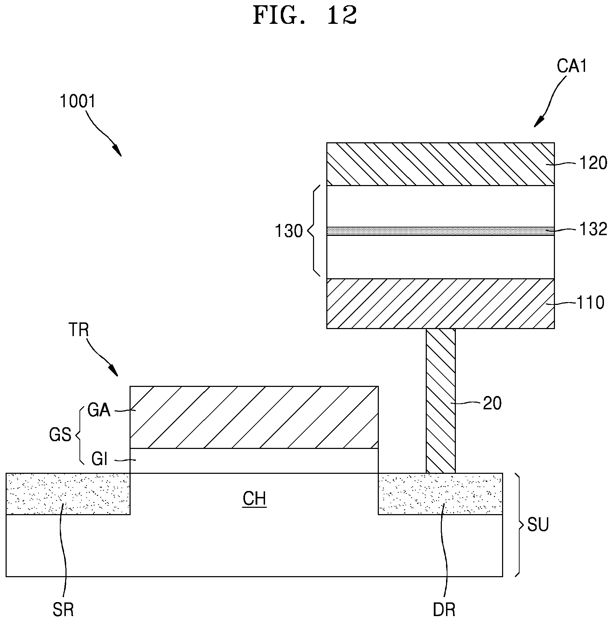

FIG. 12 is a schematic diagram illustrating an electronic device 1001 according to at least one embodiment.

Referring to FIG. 12, the electronic device 1001 may include a structure in which a capacitor CA1 and a transistor TR are electrically connected to each other through a contact 20. The capacitor CA1 may include a first electrode 110, a second electrode 120, a dielectric layer 130 disposed between the first electrode 110 and the second electrode 120, and an intervening layer 132 disposed inside the dielectric layer 130. The capacitor CA1 may be the capacitors 100 and/or 100a described with reference to FIGS. 1 to 10. Because this has been described above, detailed descriptions thereof are omitted.

The transistor TR may be a field effect transistor. The transistor TR includes a semiconductor substrate SU and a gate stack GS. The semiconductor substrate SU includes a source region SR, a drain region DR, and a channel region CH. The gate stack GS is disposed on the semiconductor substrate SU and faces the channel region CH. The gate stack GS includes a gate insulating layer GI and a gate electrode GA.

The channel region CH is a region between the source region SR and the drain region DR and is electrically connected to the source region SR and the drain region DR. The source region SR may be electrically connected to or in contact with one end of the channel region CH, and the drain region DR may be electrically connected to or in contact with the other end of the channel region CH. The channel region CH may be defined as a substrate region between the source region SR and the drain region DR in the semiconductor substrate SU.

The semiconductor substrate SU may include a semiconductor material. The semiconductor substrate SU may include, for example, an elemental semiconductor material and/or a compound semiconductor material, such as silicon (Si), germanium (Ge), silicon germanium (SiGe), silicon carbide (SiC), gallium arsenide (GaAs), indium arsenide (InAs), or indium phosphide (InP). In addition, the semiconductor substrate SU may include a silicon on insulator (SOI) substrate.

In at least some embodiments, the source region SR, the drain region DR, and the channel region CH may each independently be formed by implanting impurities into different regions of the semiconductor substrate SU. In this case, the source region SR, the channel region CH, and the drain region DR may each include a material of the substrate as a base material. In some embodiments, the source region SR and the drain region DR may each include a conductive material. In this case, the source region SR and the drain region DR may each include, for example, a metal, a metal compound, or a conductive polymer.

In some embodiments, channel region CH may be implemented as a separate material layer (thin film), unlike the illustration thereof. In this case, for example, the channel region CH may include at least one of Si, Ge, SiGe, a Group III-V semiconductor, an oxide semiconductor, a nitride semiconductor, an oxynitride semiconductor, a two-dimensional (2D) material, a quantum dot (QD), and an organic semiconductor. For example, the oxide semiconductor may include InGaZnO or the like, the 2D material may include transition metal dichalcogenide (TMD) or graphene, and the QD may include a colloidal QD or a nanocrystal structure.

The gate electrode GA may be disposed on the semiconductor substrate SU and may face the channel region CH while being apart from the semiconductor substrate SU. The gate electrode GA may include at least one of a metal, a metal nitride, a metal carbide, and polysilicon. For example, the metal may include at least one of aluminum (Al), tungsten (W), molybdenum (Mo), titanium (Ti), and tantalum (Ta), and the metal nitride may include at least one of titanium nitride (TiN) and tantalum nitride (TaN). The metal carbide may include at least one of aluminum-doped (or aluminum-containing) metal carbide and silicon-doped (or silicon-containing) metal carbide. Specific examples of the metal carbide may include TiAlC, TaAlC, TiSiC, or TaSiC.

The gate electrode GA may have a structure in which a plurality of materials are stacked. For example, the gate electrode GA may have a structure (e.g., TiN/Al) in which a metal nitride layer and a metal layer are stacked, or a structure (e.g., TiN/TiAlC/W) in which a metal nitride layer, a metal carbide layer, and a metal layer are stacked. However, the materials described above are only an example.

The gate insulating layer GI may be further arranged between the semiconductor substrate SU and the gate electrode GA. The gate insulating layer GI may include a paraelectric material or a high-k dielectric material, and may have a dielectric constant of about 20 to about 70.

The gate insulating layer GI may include silicon oxide, silicon nitride, aluminum oxide, hafnium oxide, zirconium oxide, or the like, or may include a 2D insulator, such as hexagonal boron nitride (h-BN). For example, the gate insulating layer GI may include silicon oxide (SiO₂), silicon nitride (SiNx), or the like, and may include hafnium oxide (HfO₂), hafnium silicon oxide (HfSiO₄), lanthanum oxide (La₂O₃), lanthanum aluminum oxide (LaAlO₃), zirconium oxide (ZrO₂), hafnium zirconium oxide (HfZrO₂), zirconium silicon oxide (ZrSiO₄), tantalum oxide (Ta₂O₅), titanium oxide (TiO₂), strontium titanium oxide (SrTiO₃), yttrium oxide (Y₂O₃), aluminum oxide (Al₂O₃), lead scandium tantalum oxide (PbSc_{0.5}Ta_{0.5}O₃), lead zinc niobate (PbZnNbO₃), or the like. In addition, the gate insulating layer GI may include metal nitride oxide (e.g., aluminum oxynitride (AlON), zirconium oxynitride (ZrON), hafnium oxynitride (HfON), lanthanum oxynitride (LaON), yttrium oxynitride (YON), etc.), silicate (e.g., ZrSiON, HfSiON, YSiON, LaSiON, etc.), or aluminate (e.g., ZrAlON, HfAlON, etc.). The gate insulating layer GI may constitute a gate stack together with the gate electrode GA.

One of the first and second electrodes 110 and 120 of the capacitor CA1 and one of the source region SR and the drain region DR of the transistor TR may be electrically connected to each other through the contact 20. The contact 20 may include an appropriate conductive material, for example, tungsten, copper, aluminum, or polysilicon.

The arrangement of the capacitor CA1 and the transistor TR may be variously modified. For example, the capacitor CA1 may be disposed on the semiconductor substrate SU, or may be buried in the semiconductor substrate SU.

FIG. 12 illustrates that the electronic device 1001 includes one capacitor CA1 and one transistor TR, but this is only an example, and the electronic device 1001 may be included as one of a plurality of electronic devices 10001 including a plurality of capacitors CA1 and a plurality of corresponding transistors TR.

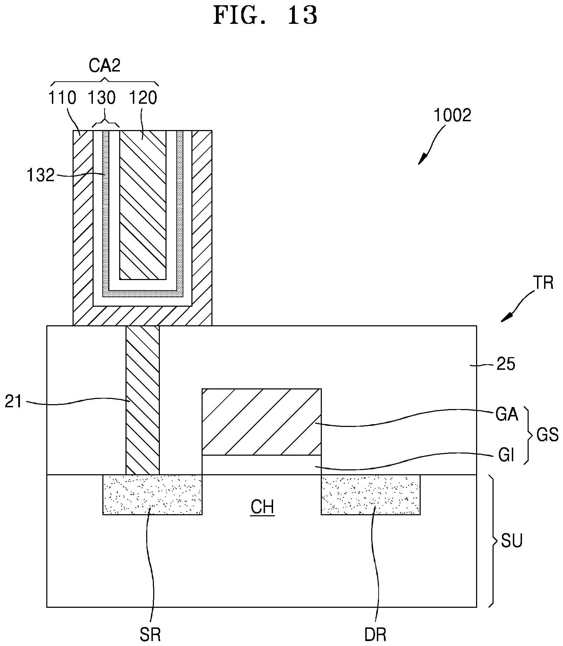

FIG. 13 is a schematic diagram illustrating an electronic device 1002 according to another at least one embodiment.

Referring to FIG. 13, the electronic device 1002 may include a structure in which a capacitor CA2 and a transistor TR are electrically connected to each other through a contact 21. The transistor TR includes a semiconductor substrate SU and a gate stack GS. The semiconductor substrate SU includes a source region SR, a drain region DR, and a channel region CH. The gate stack GS is disposed on the semiconductor substrate SU, faces the channel region CH, and includes a gate insulating layer GI and a gate electrode GA.

An interlayer insulating layer 25 may be disposed on the semiconductor substrate SU to cover the gate stack GS. The interlayer insulating layer 25 may include an insulating material. For example, the interlayer insulating layer 25 may include Si oxide (e.g., SiO₂), Al oxide (e.g., Al₂O₃), or a high-k material (e.g., HfO₂). The contact 21 passes through the interlayer insulating layer 25 to electrically connect the transistor TR to the capacitor CA2.

The capacitor CA2 may include a first electrode 110, a second electrode 120, a dielectric layer 130 disposed between the first electrode 110 and the second electrode 120, and an intervening layer 132 disposed inside the dielectric layer 130. The first electrode 110 and the second electrode 120 are provided in a shape increasing the contact area with the dielectric layer 130, and the material of the capacitor CA2 is the same as and/or substantially similar to the material of the capacitors 100 and 100a described with reference to FIGS. 1 to 10.

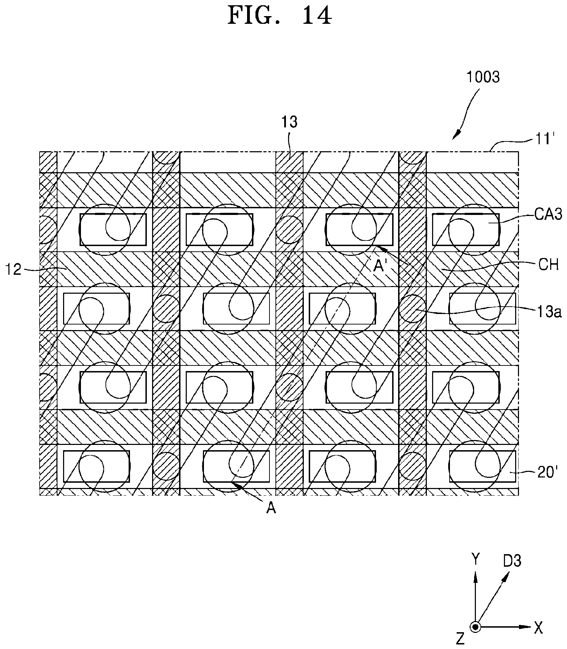

FIG. 14 is a plan view illustrating an electronic device 1003 according to another at least one embodiment.

Referring to FIG. 14, the electronic device 1003 may include a structure in which a plurality of capacitors and a plurality of field effect transistors are repeatedly arranged. The electronic device 1003 may include a field effect transistor, a contact structure 20', and a capacitor CA3. The field effect transistor includes a semiconductor substrate 11' including a source, a drain, and a channel, and a gate stack 12. The contact structure 20' is disposed on the semiconductor substrate 11' so as not to overlap the gate stack 12. The capacitor CA3 is disposed on the contact structure 20'. The electronic device 1003 may further include a bit line structure 13 electrically connecting the field effect transistors to each other.

Although FIG. 14 illustrates that both the contact structure 20' and the capacitor CA3 are repeatedly arranged in the X and Y directions, the disclosure is not limited thereto. For example, the contact structure 20' may be arranged in the X and Y directions, and the capacitor CA3 may be arranged in a hexagonal shape, such as a honeycomb structure.

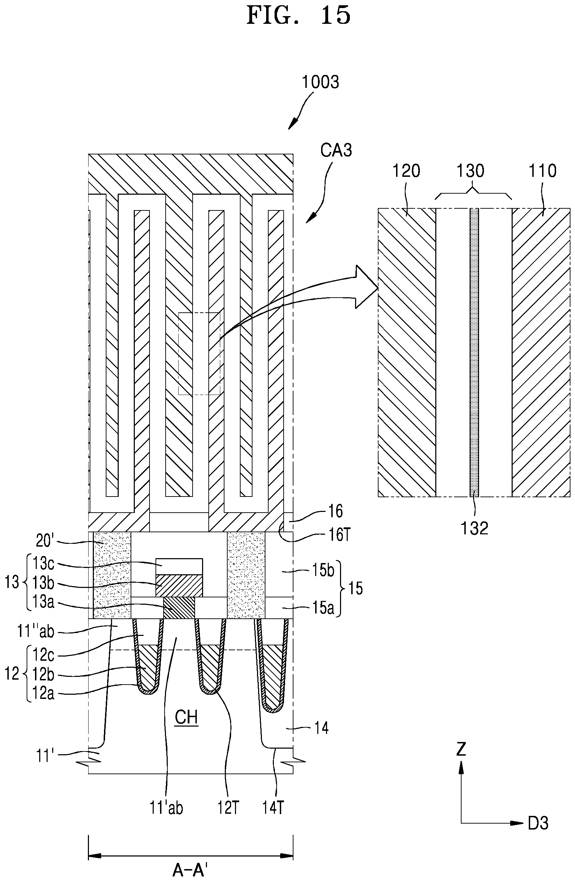

FIG. 15 is a cross-sectional view of the electronic device of FIG. 14 taken along line A-A' of FIG. 14.

Referring to FIG. 15, the semiconductor substrate 11' may have a shallow trench isolation (STI) structure including a device isolation layer 14. The device isolation layer 14 may be a single layer including one type of insulating layer, or multiple layers including a combination of two or more types of insulating layers. The device isolation layer 14 may include a device isolation trench 14T in the semiconductor substrate 11', and the device isolation trench 14T may be filled with an insulating material. The insulating material may include at least one of fluoride silicate glass (FSG), undoped silicate glass (USG), boro-phospho-silicate glass (BPSG), phospho-silicate glass (PSG), flowable oxide (FOX), plasma enhanced tetra-ethyl-ortho-silicate (PE-TEOS), and tonen silazene (TOSZ), but the disclosure is not limited thereto.

The semiconductor substrate 11' may further include a channel region CH defined by the device isolation layer 14, and a gate line trench 12T parallel to the upper surface of the semiconductor substrate 11' and extending in the X direction. The channel region CH may have a relatively long island shape having a minor axis and a major axis. The major axis of the channel region CH may be arranged in a D3 direction parallel to the upper surface of the semiconductor substrate 11', as illustrated in FIG. 14.

The gate line trench 12T may be arranged to cross the channel region CH at a certain depth from the upper surface of the semiconductor substrate 11', or may be arranged inside the channel region CH. The gate line trench 12T may also be arranged inside the device isolation trench 14T. The gate line trench 12T inside the device isolation trench 14T may have a lower bottom surface than that of the gate line trench 12T of the channel region CH. A first source/drain 11'ab and a second source/drain 11"ab may be arranged in an upper portion of the channel region CH located at both sides of the gate line trench 12T.

The gate stack 12 may be arranged inside the gate line trench 12T. Specifically, a gate insulating layer 12a, a gate electrode 12b, and a gate capping layer 12c may be sequentially arranged inside the gate line trench 12T. The gate insulating layer 12a and the gate electrode 12b may be the same as described above, and the gate capping layer 12c may include at least one of silicon oxide, silicon oxynitride, and silicon nitride. The gate capping layer 12c may be arranged on the gate electrode 12b to fill the remaining portion of the gate line trench 12T.

A bit line structure 13 may be disposed on the first source/drain 11'ab. The bit line structure 13 may be arranged parallel to the upper surface of the semiconductor substrate 11' and extend in the Y direction. The bit line structure 13 may be electrically connected to the first source/drain 11"ab and may include a bit line contact 13a, a bit line 13b, and a bit line capping layer 13c, which are sequentially stacked on the semiconductor substrate 11'. For example, the bit line contact 13a may include polysilicon, the bit line 13b may include a metal material, and the bit line capping layer 13c may include an insulating material, such as silicon nitride or silicon oxynitride.

Although FIG. 15 illustrates that the bit line contact 13a has a bottom surface at the same level as the upper surface of the semiconductor substrate 11', this is only an example and the disclosure is not limited thereto. For example, in another at least one embodiment, a recess formed to a certain depth from the upper surface of the semiconductor substrate 11' may be further provided. The bit line contact 13a may extend to the inside of the recess so that the bottom surface of the bit line contact 13a is lower than the upper surface of the semiconductor substrate 11'.

The bit line structure 13 may further include a bit line intermediate layer (not illustrated) between the bit line contact 13a and the bit line 13b. The bit line intermediate layer may include metal silicide, such as tungsten silicide, or metal nitride, such as tungsten nitride. In addition, a bit line spacer (not illustrated) may be further formed on a sidewall of the bit line structure 13. The bit line spacer may have a single-layer structure or a multilayer structure and may include an insulating material, such as silicon oxide, silicon oxynitride, or silicon nitride. In addition, the bit line spacer may further include an air space (not illustrated).

The contact structure 20' may be disposed on the second source/drain 11"ab. The contact structure 20' and the bit line structure 13 may be disposed on different sources/drains on the semiconductor substrate 11'. The contact structure 20' may have a structure in which a lower contact pattern (not illustrated), a metal silicide layer (not illustrated), and an upper contact pattern (not illustrated) are sequentially stacked on the second source/drain 11"ab. The contact structure 20' may further include a barrier layer (not illustrated) surrounding the side surface and the bottom surface of the upper contact pattern. For example, the lower contact pattern may include polysilicon, the upper contact pattern may include a metal material, and the barrier layer may include a conductive metal nitride.

The capacitor CA3 may be disposed on the semiconductor substrate 11' and electrically connected to the contact structure 20'. Specifically, the capacitor CA3 includes a first electrode 110 electrically connected to the contact structure 20', a second electrode 120 apart from the first electrode 110, a dielectric layer 130 disposed between the first electrode 110 and the second electrode 120, and an intervening layer 132 disposed inside the dielectric layer 130. The first electrode 110 may have a cylindrical cup shape, an elongated cup shape, etc. having an internal space with a closed bottom. The second electrode 120 may have a comb shape having comb teeth extending into an internal space formed by the first electrode 110 and a region between the adjacent first electrodes 110. The dielectric layer 130 may be arranged between the first electrode 110 and the second electrode 120 so as to be parallel to the surfaces of the first electrode 110 and the second electrode 120. Because materials of the first electrode 110, the second electrode 120, the dielectric layer 130, and the intervening layer 132 constituting the capacitor CA3 are the same as and/or substantially similar to those of the capacitors 100 and 100a described with reference to FIGS. 1 to 10, detailed descriptions thereof are omitted.

An interlayer insulating layer 15 may be further arranged between the capacitor CA3 and the semiconductor substrate 11'. The interlayer insulating layer 15 may be arranged in a space between the capacitor CA3 and the semiconductor substrate 11', in which other structures are not arranged. Specifically, the interlayer insulating layer 15 may be arranged to cover a wiring and/or electrode structure, such as the bit line structure 13, the contact structure 20', and the gate stack 12 on the semiconductor substrate 11'. For example, the interlayer insulating layer 15 may surround a wall of the contact structure 20'. The interlayer insulating layer 15 may include a first interlayer insulating layer 15a surrounding the bit line contact 13a, and a second interlayer insulating layer 15b covering the side surfaces and/or the upper surfaces of the bit line 13b and the bit line capping layer 13c.

The second electrode 120 of the capacitor CA3 may be arranged on the interlayer insulating layer 15, specifically on the second interlayer insulating layer 15b. In addition, when a plurality of capacitors CA3 are arranged, bottom surfaces of a plurality of second electrodes 120 may be separated from each other by an etch stop layer 16. In other words, the etch stop layer 16 may include an opening 16T, and the bottom surface of the second electrode 120 of the capacitor CA3 may be arranged in the opening 16T. As illustrated, the second electrode 120 may have a cylindrical shape or a cup shape having an internal space with a closed bottom. The capacitor CA3 may further include a support (not shown) that prevents the second electrode 120 from being tilted or collapsed. The support may be disposed on the sidewall of the second electrode 120.

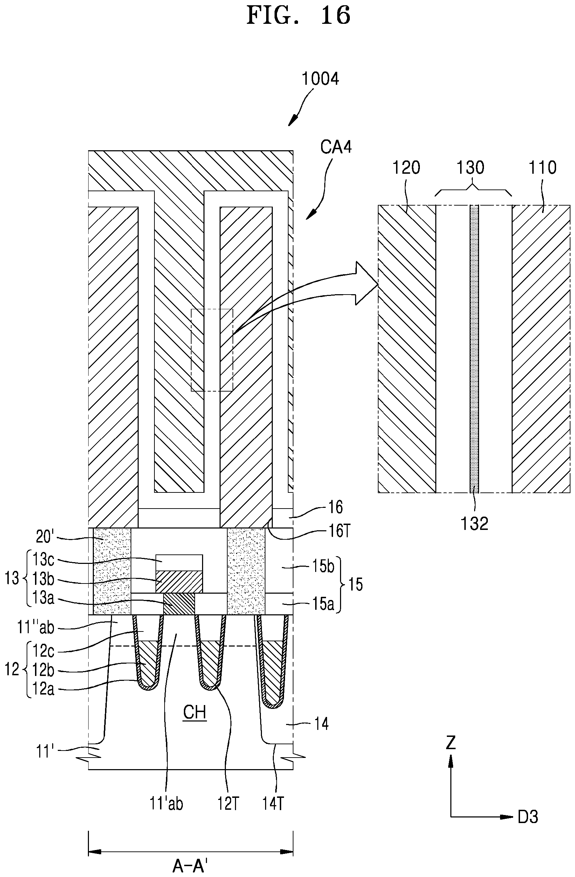

FIG. 16 is a cross-sectional view illustrating an electronic device 1004 according to another at least one embodiment.

The cross-sectional view of the electronic device 1004 according to the present embodiment corresponds to the cross-sectional view taken along line A-A' of FIG. 14, and the electronic device 1004 of FIG. 16 differs from the electronic device 1003 of FIG. 15 only in a shape of a capacitor CA4. The capacitor CA4 is disposed on a semiconductor substrate 11' and electrically connected to a contact structure 20'. The capacitor CA4 includes a first electrode 110 electrically connected to the contact structure 20', a second electrode 120 apart from the first electrode 110, a dielectric layer 130 disposed between the first electrode 110 and the second electrode 120, and an intervening layer 132 disposed inside the dielectric layer 130. Materials of the first electrode 110, the second electrode 120, the dielectric layer 130, and the intervening layer 132 are the same as those of the capacitors 100 and 100a described with reference to FIGS. 1 to 10.

The first electrode 110 may have a pillar shape, such as a cylinder, a square pillar, or a polygonal pillar, which extends in the vertical direction (Z direction). The second electrode 120 may have a comb shape having comb teeth extending into a region between the adjacent first electrodes 110. The dielectric layer 130 may be arranged between the first electrode 110 and the second electrode 120 so as to be parallel to the surfaces of the first electrode 110 and the second electrode 120.

The capacitors and the electronic devices according to the embodiments described above may be applied to various application fields. For example, the electronic devices according to the embodiments may be applied as logic devices or memory devices. The electronic devices according to the embodiments may be used for arithmetic operations, program execution, temporary data retention, and the like in devices such as mobile devices, computers, laptop computers, sensors, network devices, and neuromorphic devices. In addition, the electronic devices according to the embodiments may be useful for devices in which an amount of data transmission is large and data transmission is continuously performed.

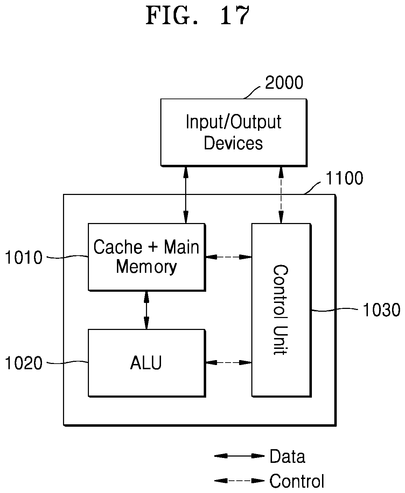

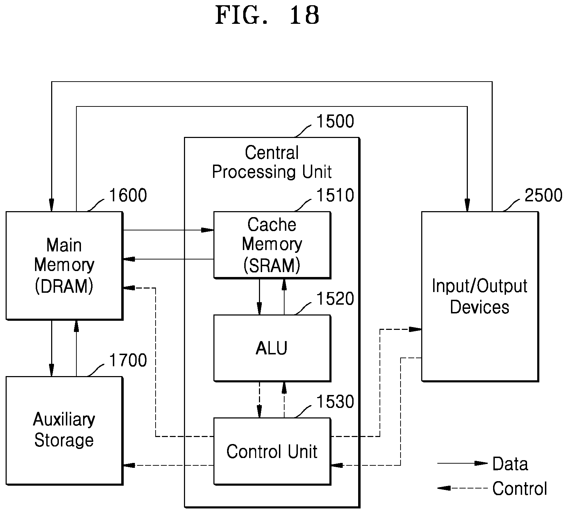

FIGS. 17 and 18 are respectively conceptual diagrams schematically illustrating a device architecture applicable to an apparatus, according to at least one embodiment.

Referring to FIG. 17, an electronic device architecture 1100 may include a memory unit 1010, an arithmetic logic unit (ALU) 1020, and a control unit 1030. The memory unit 1010, the ALU 1020, and the control unit 1030 may be electrically connected to each other. For example, the electronic device architecture 1100 may be implemented as a single chip including the memory unit 1010, the ALU 1020, and the control unit 1030.

The memory unit 1010, the ALU 1020, and the control unit 1030 may be interconnected in an on-chip manner via a metal line to perform direct communication. The memory unit 1010, the ALU 1020, and the control unit 1030 may be monolithically integrated on a single substrate to constitute a single chip. Input/output devices 2000 may be connected to the electronic device architecture (chip) 1100. In addition, the memory unit 1010 may include both a main memory and a cache memory. The electronic device architecture (chip) 1100 may be an on-chip memory processing unit. The memory unit 1010 may include the capacitor and/or the electronic device including the same, which have been described above. The ALU 1020 or the control unit 1030 may also include the capacitor described above.

Referring to FIG. 18, a cache memory 1510, an ALU 1520, and a control unit 1530 may constitute a central processing unit (CPU) 1500. The cache memory 1510 may include a static random access memory (SRAM). Apart from the CPU 1500, a main memory 1600 and an auxiliary storage 1700 may be provided. The main memory 1600 may be a DRAM and may include the capacitor and/or the electronic device including the same, which have been described above. In some cases, the electronic device architecture may be implemented in a form in which computing unit elements and memory unit elements are adjacent to each other on a single chip, without distinction of sub-units.

It should be understood that some example embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A capacitor comprising:
a first electrode;
a second electrode facing the first electrode; and
a dielectric layer between the first electrode and the second electrode, the dielectric layer including an intervening layer in the dielectric layer, and the intervening layer including aluminum oxide and gallium oxide.

2. The capacitor of claim 1, wherein the intervening layer includes AlₐGa_{b}O₃, wherein 0<a<2 and 0<b<2, and optionally wherein a ratio of gallium to aluminum in the intervening layer satisfies 0.1≤b/a≤1, and further optionally wherein a ratio of gallium to aluminum in the intervening layer satisfies 0.33≤b/a≤1.

3. The capacitor of claim 1 or 2, wherein the dielectric layer further comprises a first dielectric material layer adjacent to the first electrode, and
a second dielectric material layer adjacent to the second electrode, and
wherein the intervening layer is between the first dielectric material layer and the second dielectric material layer, and optionally wherein the first dielectric material layer and the second dielectric material layer include a same dielectric material.

4. The capacitor of claim 3, wherein each of the first dielectric material layer and the second dielectric material layer include a dielectric material is different from a dielectric material of the intervening layer.

5. The capacitor of claim 3 or 4, wherein each of the first dielectric material layer and the second dielectric material layer includes at least one dielectric material selected from zirconium oxide, hafnium oxide, hafnium zirconium oxide, a perovskite, or a mixture thereof.

6. The capacitor of any of claims 3 to 5, wherein a composition ratio of the aluminum oxide and a composition ratio of the gallium oxide continuously change along the first dielectric material layer, the intervening layer, and the second dielectric material layer.

7. The capacitor of claim 6, wherein a peak of the composition ratio of the aluminum oxide and a peak of the composition ratio of the gallium oxide are inside the intervening layer, and optionally at a same position inside the intervening layer.

8. The capacitor of claim 6, wherein the composition ratio of the aluminum oxide and the gallium oxide continuously increase toward the intervening layer at an interface between the first dielectric material layer and the intervening layer and continuously decrease from the intervening layer toward the second dielectric material layer.

9. The capacitor of any of claims 3 to 8, wherein materials of the first dielectric material layer and the second dielectric material layer are distributed in the intervening layer.

10. The capacitor of claim 9, wherein, at a center of the intervening layer, a composition ratio of the materials of the first dielectric material layer and the second dielectric material layer is less than either: a sum of composition ratios of the aluminum oxide and the gallium oxide or a composition ratio of the aluminum oxide.

11. The capacitor of claim 9, wherein, at a center of the intervening layer, a composition ratio of the materials of the first dielectric material layer and the second dielectric material layer is greater than a composition ratio of the gallium oxide.

12. The capacitor of any preceding claim, wherein the dielectric layer has a thickness of 3 nm to 10 nm.

13. The capacitor of any preceding claim, wherein the intervening layer has a thickness of 1 nm or less.

14. The capacitor of any preceding claim, wherein each of the first electrode and the second electrode includes at least one conductive metal selected from titanium (Ti), nickel (Ni), aluminum (Al), tantalum (Ta), tungsten (W), platinum (Pt), lead (Pd), gold (Au), iridium (Ir), rhodium (Rh), molybdenum (Mo), vanadium (V), niobium (Nb), ruthenium (Ru), and cobalt (Co), a conductive metal oxide of the at least one conductive metal, a conductive metal nitride of the at least one conductive metal, or a combination thereof.

15. An electronic device comprising:
a transistor; and
a capacitor according to any preceding claim electrically connected to the transistor.
